# EUROPEAN PATENT APPLICATION

(11) **EP 4 618 156 A1**
(43) Date of publication of application: **17.09.2025**
(21) Application number: 24162944.3
(22) Date of filing: 12.03.2024
(51) Int. Cl.: H01L 29/10, H01L 29/40, H01L 29/205, H01L 29/08, H01L 29/267, H01L 29/423, H01L 29/808, H01L 29/78, H01L 29/49

(54) **A SEMI-VERTICAL TRANSISTOR DEVICE**

(71) Applicant: Huawei Technologies Co., Ltd., Shenzhen, Guangdong 518129 (CN)
(72) Inventor: CURATOLA, Gilberto, 80992 Munich (DE); MOUHOUBI, Samir, 80992 Munich (DE)
(74) Representative: Roth, Sebastian

(57) **Abstract**

This disclosure relates to a transistor device, e.g. based on GaN, and a method for fabricating the transistor device. The transistor device has a semi-vertical design The transistor device comprises a buffer layer and a channel layer of first semiconductor material, and a barrier layer of second semiconductor material on the channel layer. Further, a fm structure of the first semiconductor material extending on the channel layer. The fm structure also extends from the channel layer through an opening in the barrier layer. Dielectric material is arranged on the barrier layer on opposite sides of the fin structure, and two gate contacts are embedded in the dielectric material on opposite sides of the fin structure. Two drain contacts are connected to the ends of a channel formed in the channel layer and a source contact is arranged on a top surface of the fm structure.

## Description

### TECHNICAL FIELD

The present disclosure relates to a transistor device, which may be based on gallium nitride (GaN). The disclosure provides such a transistor device, and a method for fabricating the transistor device. The disclosure is especially concerned with extending a channel of the transistor device from the horizontal plane into the vertical, so as to design a semi-vertical transistor device.

### BACKGROUND

GaN technology for power applications is being developed by most established semiconductor power manufactures, and holds the great promise to replace conventional silicon technology. The main advantages of wide bandgap materials, like GaN or silicon carbide (SiC), for example, include the capability of withstanding higher electric fields for the same design of a drift region. This translates into the possibility of having smaller power devices compared to conventional silicon counterparts. Moreover, wide bandgap materials offer a smaller device capacitance, and the possibility to reach a higher switching frequency. These benefits at system level are easily translated into better performance, higher power density, and smaller weight and volume of the system.

One key difference, for example, between the conventional GaN and silicon technologies for power transistor devices is that GaN is a lateral technology. This means that the gate, the source and the drain contacts of a transistor device are arranged on the same surface, and the current flows in a lateral direction, rather than in a vertical direction like in conventional silicon power MOSFETs. This has the big advantage that the device performance can be adjusted by simply changing the lateral layout.

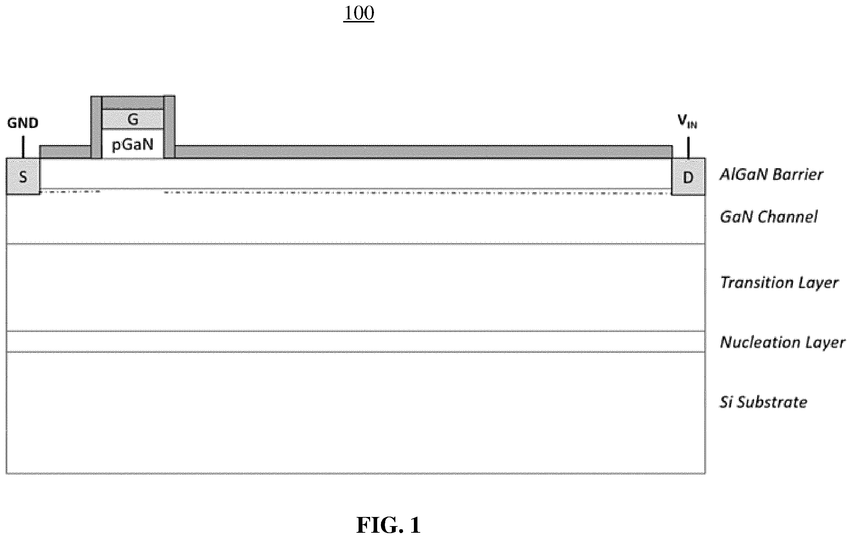

A common approach that is followed by most GaN manufacturers is the so-called p-GaN gate approach. In this approach an aluminum gallium nitride (AlGaN) barrier is grown on top of a GaN channel layer. Due to the presence of spontaneous and piezoelectric polarization charge, a high density electron inversion layer is formed at the interface between the AlGaN barrier layer and the GaN channel layer. In order to deplete this two-dimensional electron gas (2DEG) - also referred to as channel in this disclosure - below a gate region, a p-type doped GaN layer is inserted between a metal gate layer and the AlGaN barrier, only in the gate region. This allows achieving a normally-off operation, i.e., a positive threshold voltage. A schematic representation of such an exemplary p-GaN transistor device is depicted in FIG. 1.

Conventional GaN based power transistor devices have certain drawbacks. For one, the lateral GaN technology is inherently less efficient than a vertical technology, for example, in terms of area (A) utilization and hence R_{DSON}*A, where R_{DSON} is the on-resistance. Further, the p-GaN gate approach shown in FIG. 1 may lead to dynamic instabilities of the threshold voltage V_{TH} and/or to a low static V_{TH}. Schottky p-GaN gates have also gate reliability issues. In addition, the GaN on silicon epitaxial growth in the conventional transistor devices, which are implemented using nucleation and transition layers as shown in FIG. 1, may lead to dynamic effects like current collapse or dynamic R_{DSON}. This is a consequence of defects and/or dislocations caused by the epitaxial growth. The conventional transistor devices moreover offer only very few degrees of freedom, which may be used to influence the V_{TH}, the electric field, or the device reliability.

### SUMMARY

In view of the above, an objective of this disclosure is to provide a transistor device that allows overcoming the issues that affect the conventional approaches for power transistor devices. An objective is, for example, to benefit from introducing vertical GaN technology. Another objective is to reduce the dimensions of the transistor device compared to conventional ones. Another objective is to provide more degrees of freedom allowing tuning V_{TH}. Another objective is an improved breakdown voltage of the transistor device.

These and other objectives are achieved by the solutions of this disclosure described in the independent claims. Advantageous implementations are further described in the dependent claims.

A first aspect of this disclosure provides a transistor device comprising: a buffer layer made of a first semiconductor material; a channel layer made of the first semiconductor material and arranged on the buffer layer; a barrier layer made of a second semiconductor material and arranged on the channel layer; a fin structure made of the first semiconductor material and arranged on the channel layer, wherein the fin structure extends from the channel layer along a first axis through an opening in the barrier layer and extends on the channel layer along a second axis, which is perpendicular to the first axis; a dielectric material arranged on the barrier layer, wherein the dielectric material is arranged on opposite sides of the fin structure along a third axis, which is perpendicular to the first and the second axis; two drain contacts, wherein each end of a channel formed in the channel layer at its interface to the barrier layer is electrically connected to one of the drain contacts; a source contact arranged on a top surface of the fin structure; and two gate contacts embedded in the dielectric material on opposite sides of the fin structure.

The transistor device of the first aspect allows a reduction of the device dimensions compared to a conventional transistor device, due to its semi-vertical structure. This may further achieve improved breakdown capabilities. Moreover, the threshold voltage V_{TH} can be tuned by changing the device dimensions, in particular, the dimensions of the fin structure. Thus, new degrees of freedom are provided. The transistor device of the first aspect combines the advantages of lateral technology and vertical technology. The device design can be considered being a super-position of a lateral HEMT and a vertical junction field effect transistor (JFET)

In an implementation form of the first aspect, the first semiconductor material is GaN, and the second semiconductor material is AlGaN.

That is, the transistor device of the first aspect combines lateral GaN technology and vertical GaN technology.

In an implementation form of the first aspect, the gate contacts are made of nickel oxide (NiO), or lithium nickel oxide (LiNiO), or diamond.

The transistor device of the first aspect beneficially enables the use of p-type dielectric layers for making the gate contact, for example, instead of using conventional Mg-doped GaN layers.

In an implementation form of the first aspect, the gate contacts are p-doped, and the fin structure is n-doped.

In an implementation form of the first aspect, the transistor device further comprises two field plates embedded in the dielectric material on opposite sides of the fin structure, wherein each field plate is placed offset along the first axis in direction of the barrier layer from the gate contact that is placed on the same side of the fin structure.

The field plates may further improve the breakdown capabilities of the transistor device of the first aspect.

In an implementation form of the first aspect the field plates are made of NiO, or LiNiO, or diamond, and/or wherein the field plates are p-doped.

In an implementation form of the first aspect, the dielectric material is arranged between the fin structure and each gate contact.

In an implementation form of the first aspect, each gate contact is in direct contact with the fin structure.

In an implementation form of the first aspect, the dielectric material and the gate contacts embedded in the dielectric material, respectively, extend next to the entire fin structure along the second axis.

This implementation leads to a so-called strip design of the transistor device.

In an implementation form of the first aspect, the dielectric material and the gate contacts further sandwich the fin structure along the second axis, and the two gate contacts are connected to each other to form one integral gate contact that is arranged around the fin structure.

Thus, the transistor device of the first aspect is compatible with a gate all around (GAA) design.

In an implementation form of the first aspect, each of the two gate contacts is embedded in a different pillar of the dielectric material, wherein the two pillars are arranged next to the fin structure on opposite sides of the fin structure.

This implementation leads to a so-called pillar design of the transistor device.

In an implementation form of the first aspect, the transistor device comprises four or more gate contacts, wherein two or more pillars of the dielectric material are arranged on each side of the fin structure, and wherein each pillar includes one of the gate contacts.

In an implementation form of the first aspect, the transistor device comprises four or more field plates, wherein each pillar additionally includes one of the field plates.

In an implementation form of the first aspect, the two or more pillars arranged on either side of the fin structure are placed one after the other along the second axis.

In an implementation form of the first aspect, the transistor device further comprises: a second barrier layer arranged on the buffer layer and embedded in the channel layer at an offset along the first axis to the barrier layer; wherein each end of a channel formed in the buffer layer at its interface to the second barrier layer is electrically connected to one of the drain contacts.

Thus, the transistor device of the first aspect is based on a multi-channel approach, wherein multiple (two or more) barrier layers are employed and several (two or more) 2DEGs can be created in parallel in the transistor device.

In an implementation form of the first aspect, the transistor device further comprises a silicon-based substrate and a transition and/or nucleation layer arranged between the silicon-based substrate and the GaN buffer layer.

A second aspect of this disclosure provides a method for fabricating a transistor device, the method comprising: growing a buffer layer made of a first semiconductor material; growing a channel layer made of the first semiconductor material on the buffer layer; growing a barrier layer made of a second semiconductor material on the channel layer; forming a fin structure made of the first semiconductor material on the channel layer, wherein the fin structure extends from the channel layer along a first axis through an opening in the barrier layer and extends on the channel layer along a second axis, which is perpendicular to the first axis; forming a dielectric material on the barrier layer, wherein the dielectric material is formed on opposite sides of the fin structure along a third axis, which is perpendicular to the first and the second axis; forming two drain contacts, wherein each end of a channel formed in the channel layer at its interface to the barrier layer is electrically connected to one of the drain contacts; forming a source contact on a top surface of the fin structure; and embedding two gate contacts in the dielectric material on opposite sides of the fin structure.

The method of the second aspect is suitable for fabricating the transistor device of the first aspect and any implementation form thereof. The method of the second aspect may have corresponding implementation forms with steps to make the implementation forms of the first aspect. The method of the second aspect achieves the same advantages as described for the transistor device of the first aspect and its implementation forms.

In an implementation form of the method, forming the fin structure comprises: forming the opening in the barrier layer; growing a top layer of the first semiconductor material onto the barrier layer and onto the channel layer through the opening; and etching the top layer at least partly down to the barrier layer, so as to form the fin structure.

The present disclosure propose a new transistor device concept that allows overcoming most of the issues that today affects the conventional single barrier GaN approaches making use of field plates. In particular, this disclosure proposes a transistor device concept that has a better trade-off between performance and reliability than a conventional lateral p-GaN transistor device. The new concept allows reducing the lateral device dimensions, while still being able to reach comparable (if not higher) breakdown capabilities than the conventional transistor device. This is achieved thanks to the creation of the vertical fin structure, which leads to the semi-vertical design combining HEMT and JFET. This design enables a good overall device breakdown. Further, the vertical fin structure allows tuning the device threshold voltage, for example, by simply adjusting the lateral and vertical dimensions.

Moreover, the proposed transistor device concept enables the usage of p-type doped dielectric layers, like NiO or LiNiO, instead of conventional p-GaN layers for the gate contacts. This allows solving most of the common issues encountered with the usage of Mg-doped layer, like MOCVD cost, dopant activation limitation. Additionally, these p-type dielectrics can be easily sputtered on existing passivation layers, and allow to realize more complex device concepts, which are not feasible today with conventional GaN processes.

### BRIEF DESCRIPTION OF DRAWINGS

The above described aspects and implementation forms are explained in the following description in relation to the enclosed drawings, in which:
- FIG. 1: shows a conventional GaN-based lateral transistor device.
- FIG. 2: shows a semi-vertical transistor device according to this disclosure.
- FIG. 3: shows a transistor device according to this disclosure with field plates.
- FIG. 4: shows a transistor device according to this disclosure with respectively two barrier layers and channels.
- FIG. 5: shows respectively a stripe design and a pillar design of a transistor device according to this disclosure.
- FIG. 6: shows respectively a stripe design and a pillar design of another transistor device according to this disclosure.
- FIG. 7: shows a flow-diagram of a method according to this disclosure for fabricating a semi-vertical transistor device.
- FIG. 8(a-k): shows steps of an exemplary process for fabricating a transistor device according to this disclosure.

### DETAILED DESCRIPTION OF EMBODIMENTS

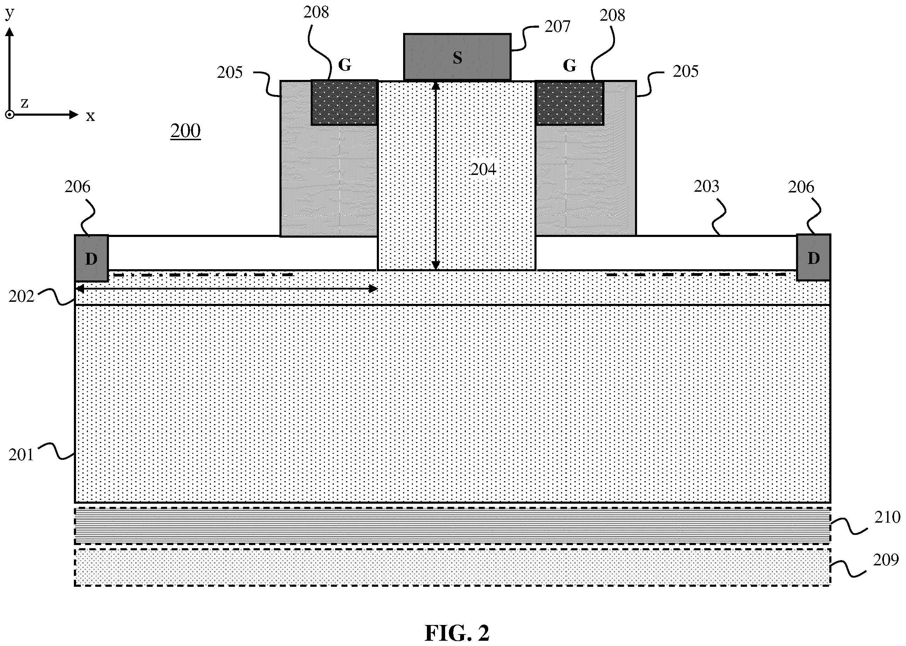

FIG. 2 shows a transistor device 200 according to this disclosure. The transistor device 200 is semiconductor-based. The transistor device 200 is based on a semi-vertical device concept that combines the advantages of lateral and vertical technologies. The transistor device 200 may be considered as super-position of a lateral HEMT and a vertical JFET. The transistor device 200 may be a GaN based transistor device, but could also be based on another e.g. wide bandgap material.

The transistor device 200 comprises a buffer layer 201, which is made of a first semiconductor material, for instance, of GaN. A GaN buffer layer 201 may be grown above an optional silicon-based substrate 209 (thus indicated with dashed lines). In this case, an optional transition and/or nucleation layer 210 may be arranged between the silicon-based substrate 209 and the GaN buffer layer 201. The buffer layer 201 may be undoped or unintentionally doped.

Further, the transistor device 200 comprises a channel layer 202, which is made of the first semiconductor material and is arranged on the buffer layer 201. In an implementation, the buffer layer 201 and the channel layer 202 may be one integral layer, e.g., the channel layer 202 is a part of the buffer layer 201. In another implementation, the channel layer 202 may be a higher-quality layer of the first semiconductor material grown on the buffer layer 201. For instance, growth conditions for the buffer layer 201 and the channel layer 202 may differ. The channel layer 202 is preferably undoped, or may be unintentionally doped.

The transistor device 200 further comprises a barrier layer 203, which is made of a second semiconductor material and is arranged on the channel layer 202. The second semiconductor material, for instance AlGaN, has usually a higher band-gap than the first semiconductor material. In the transistor device 200, a channel is formed in the channel layer 202 at the interface between the channel layer 202 and the barrier layer 203. The channel is typically a high density electron inversion layer (2DEG) formed due to the presence of spontaneous and piezoelectric polarization charge. The channel is similar to a channel in a conventional HEMT. The channel may be formed in a plane defined by the second and third axis.

The transistor device 200 further comprises a fin structure 204, which is made of the first semiconductor material, for instance, GaN. The fin structure 204 is arranged on the channel layer 202. The fin structure 204 extends from the channel layer 202 along a first axis (the y-axis or vertical axis as indicated by the coordinated system in FIG. 2) through an opening in the barrier layer 203. Additionally, the fin structure also extends on the channel layer 202 along a second axis (the z-axis pointing into the plane of FIG. 2), which is perpendicular to the first axis. The opening thus also extends along the second axis. The fin structure may thus resemble a ridge structure extending on the surface of the channel layer 202 along the second axis. The fin structure 204 may be doped, for instance, n-doped.

The transistor device 200 further comprises a dielectric material 205, which is arranged on the barrier layer 203. The dielectric material may be an oxide, for example, silicon oxide or aluminum oxide, or may be silicon nitride. The dielectric material 205 is arranged on opposite sides of the fin structure 202 along a third axis (the x-axis or horizontal axis in FIG. 2), which is perpendicular to the first and the second axis. In other words, the dielectric material 205 sandwiches the fin structure 202 in direction along the third axis. In other words, in direction of the third axis, the fin structure 204 is arranged between the dielectric material 205.

The transistor device 200 also comprises two drain contacts 206. Each end of the two ends of the channel, which is formed in the channel layer 202 at its interface to the barrier layer 203, is electrically connected to one of the drain contacts 206. The drain contacts 206 may be provided on the channel layer 202, and may penetrate the channel layer 206. The drain contacts 206 may go through the barrier layer 203. The drain contacts 206 may extend along the second axis. The drain contacts 206 may be metal contacts. The channel is indicated by the dashed-dotted line in FIG. 2.

The transistor device 200 further comprises a source contact 207, which is arranged on a top surface of the fin structure 204, i.e., on the free surface of the fin structure 204 parallel to and pointing away from the channel layer 202. The perpendicular to the top surface may be aligned along the first axis. The source contact 207 may be a metal contact. The source contact may extend on the fin structure 204 along the second axis. The transistor device 200 also comprises two gate contacts 208, which are embedded in the dielectric material 205 on opposite sides of the fin structure 204. The gate contacts 208 may thus sandwich the fin structure 204 in a direction along the third axis. The transistor device 200 may comprise more than two gate contacts 208. The gate contacts 208 may respectively be made of at least one of NiO, LiNiO, and diamond. Such gate contacts 208 may be p-doped, particularly if the fin structure 205 is n-doped.

In operation of the transistor device 200, the gate contacts 208 allow regulating a current flow between source contact 207 and drain contacts 206. The current flows through the channel (2DEG) of the lateral HEMT-like part of the transistor device 200, and through the fin structure 204 of the vertical JFET-lie part of the transistor device 200. The semi-vertical structure enables an improved breakdown voltage and reduced device dimension.

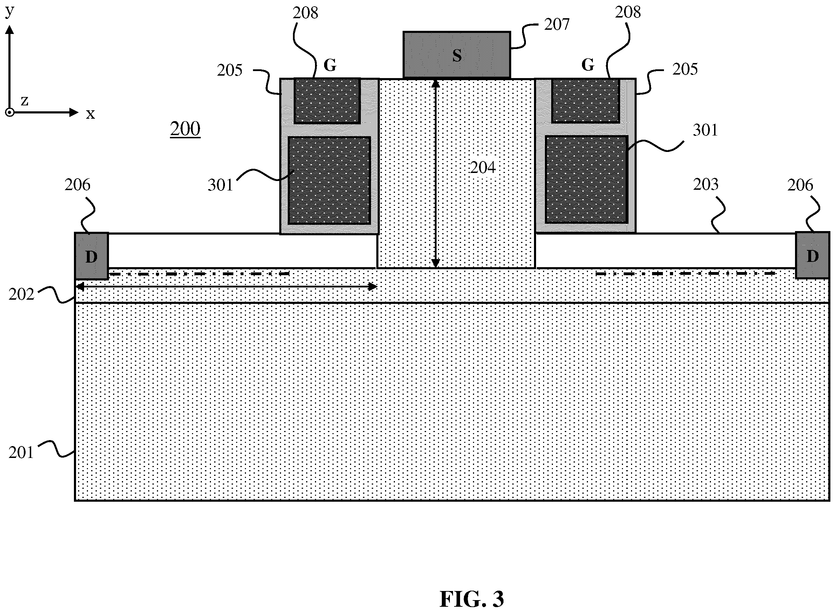

FIG. 3 shows a transistor device 200 according to this disclosure, which is based on the transistor device 200 shown in FIG. 2. Same elements in FIG. 2 and FIG. 3 are labelled with the same reference signs, can be implemented likewise, and are thus not redundantly described.

In contrast to the transistor device 200 shown in FIG. 2, the transistor device 200 shown in FIG. 3 additionally comprises two field plates 301, which are embedded in the dielectric material 205 on opposite sides of the fin structure 204. That is, the field plates 301 sandwich the fin structure 204 in a direction along the third axis. Each field plate 301 is thereby placed at an offset along the first axis, in direction of the barrier layer 203, from the gate contact 208 placed on the same side of the fin structure 204 as said filed plate 301. In other words, each field plate 301 is arranged below one of the gate contacts 208 in the dielectric material 205, wherein below means closer to the barrier layer 203. The field plates 301 may respectively be made of NiO, or LiNiO, or diamond, and/or may be p-doped. For instance, the field plates 301 may be made of the same material as the gate contacts 208.

In further contrast to the transistor device 200 shown in FIG. 2, in which each gate contact 208 is in direct contact with the fin structure 204, in the transistor device 200 shown in FIG. 3, the dielectric material 205 is arranged between the fin structure 204 and respectively each gate contact 208. However, this could be vice versa in the transistor devices 200 of FIG. 2 and FIG. 3, and is not due to the field plates 301. The field plates 301 and the gate contacts 208 could be arranged in a similar manner, however. The thickness of the dielectric material 205 between each field plate 301 and the fin structure 204 and the thickness of the dielectric material 205 between each gate contact 208 and the fin structure 204 may be the same or may be different. Further, the thickness of the dielectric material 205 between each field plate 301 and the fin structure 204 and the thickness of the dielectric material 205 between said field plate 301 and the barrier layer 203 may be the same or may be different.

The field plates 301 are able to further boost the overall device breakdown of the transistor device 200, i.e., to improve the overall breakdown capabilities of the transistor device 200. The field plates 301 may be source field plates, as they may be connected to the source contact 207. The field plates 301 may be used to modify the electric field distribution in the transistor device 200, which may reduce peak electric fields at critical points, which can improve the breakdown voltage and reduce leakage currents. By being connected to the source contact 208, the field plates 301 may help to more effectively spread the electric field and reduce hot spots that can lead to premature device failure.

The (vertical) extension of the fin structure 204 along the first axis may have a size that is comparable to the (lateral) distance between the fin structure 204 and each of the drain contacts 208. For example, the extension may be the same as the distance. In this way, a better area utilization than for the conventional GaN lateral technology can be achieved, while still having similar breakdown capabilities. This allows to significantly reduce the transistor device pitch.

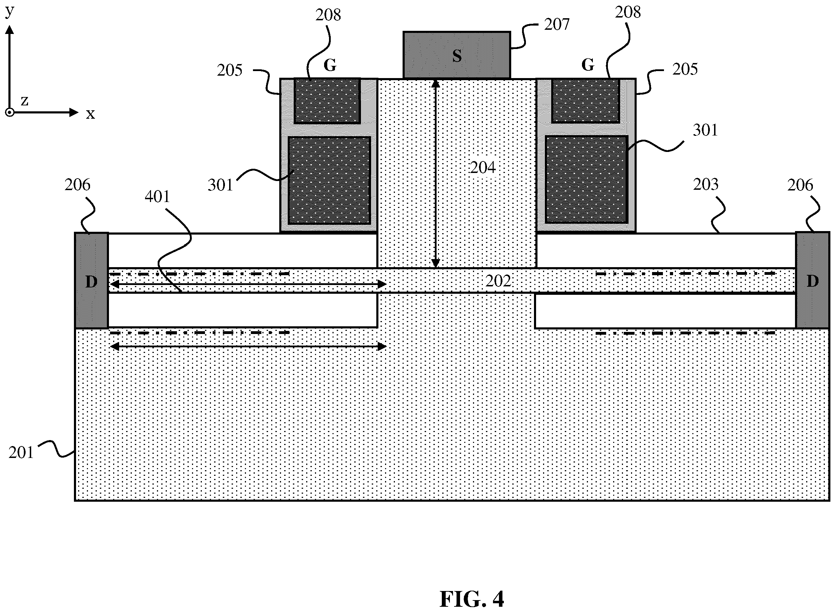

FIG. 4 shows a transistor device 200 according to this disclosure, which is based on the transistor device 200 shown FIG. 3. Same elements in FIG. 3 and FIG. 4 are labelled with the same reference signs, can be implemented likewise, and are thus not redundantly described.

The transistor device 200 of FIG. 4 is based on a multi-channel approach, in contrast to the transistor devices 200 shown in FIG. 2 and 3, which have only one channel. To this end, the transistor device 200 shown in FIG. 4 further comprises a second barrier layer 401, which is arranged on the buffer layer 201 and is embedded in the channel layer 202 at an offset along the first axis to the barrier layer 203. That is, the second barrier layer 401 is below the first barrier layer 203, wherein below means closer to e.g. a substrate 209 on which the buffer layer 202 may be grown.

In the transistor device 200 of FIG. 4, a second channel is formed in the buffer layer 201 at the interface between the buffer layer 201 and the second barrier layer 401. The channel may be a high density electron inversion layer (2DEG). Like for the first channel mentioned previously for the first barrier layer 203, also each end of the two ends of the second channel along the third axis is electrically connected to one of the drain contacts 206.

Notably, the transistor device 200 can have more than two such barrier layers, for instance AlGaN barrier layers, and may comprise more than two channels (2DEGs) that may be stacked along the first axis. Moreover, it must be noted that the transistor device 200 shown in FIG. 4 could also be implemented without the field plates 301. Moreover, the gate contacts 208 could directly contact the fin structure 204, as in FIG. 2.

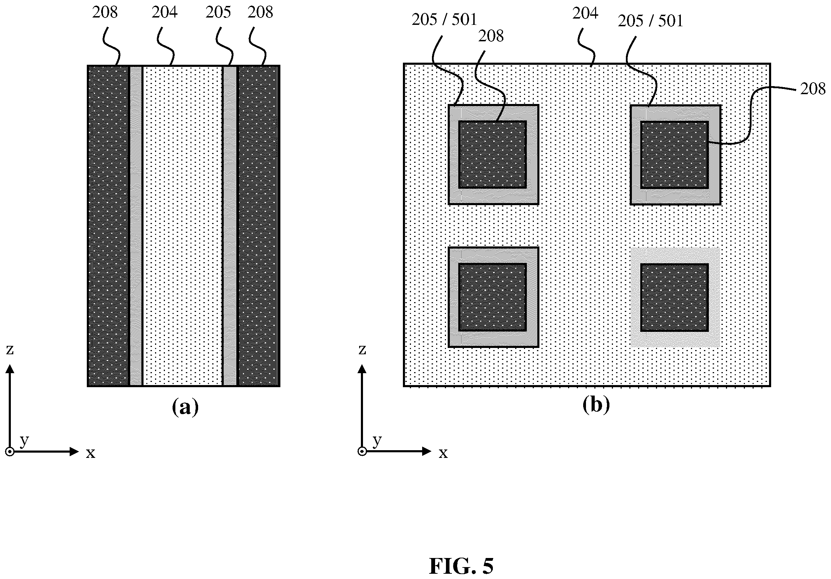

FIG. 5 shows top views of two differently-designed transistor devices 200 according to this disclosure. The transistor devices 200 may respectively be implemented as in FIG. 2, 3 or 4. FIG. 5(a) shows a so-called stripe design of the transistor device 200 according to this disclosure, and FIG. 5(b) shows a so-called pillar design of the transistor device 200.

In FIG. 5(a), the dielectric material 205 and the gate contacts 208, which are respectively embedded in the dielectric material 205, extend next to the entire fin structure 204 (or at least most of the length of the fin structure 204) along the second axis. In a variation of this implementation, the dielectric material 205 and the gate contacts 208 could additionally sandwich the fin structure 204 in direction along the second axis. That is, gate contacts 208 could be arranged adjacent to both ends of the fin structure 204 with respect to its extension along the second axis. In this case, the two gate contacts 208 could be connected to each other to form one integral gate contact that is arranged around the fin structure 204. In this way, a GAA design may be enabled.

In FIG. 5(b), each of the two gate contacts 208 is embedded in a pillar 501 of the dielectric material 205, particularly a different pillar 501. For instance, different pillar shapes may be implemented. For example, a pillar 501 may have a square shape, rectangular shape, circular shape or hexagonal shape (when viewed along the first axis). Different pillars 501 may have different shapes or the same shape. The two pillars 501 are arranged next to the fin structure 204 on opposite sides of the fin structure 204. That is the pillars 501 sandwich the fin structure in a direction along the third axis. Each pillar 501 includes one of the gate contacts 208 of the transistor device 200, and each pillar 501 may additionally include one field plate 301. In this pillar design, the transistor device 200 can include more than two gate contacts 208, for example, four (or even more) gate contacts 208 as shown. As also shown for this case, two (or even more) dielectric material pillars 501 of are arranged on each side of the fin structure 204, each including one gate contact 208 and optionally one field plate 301.

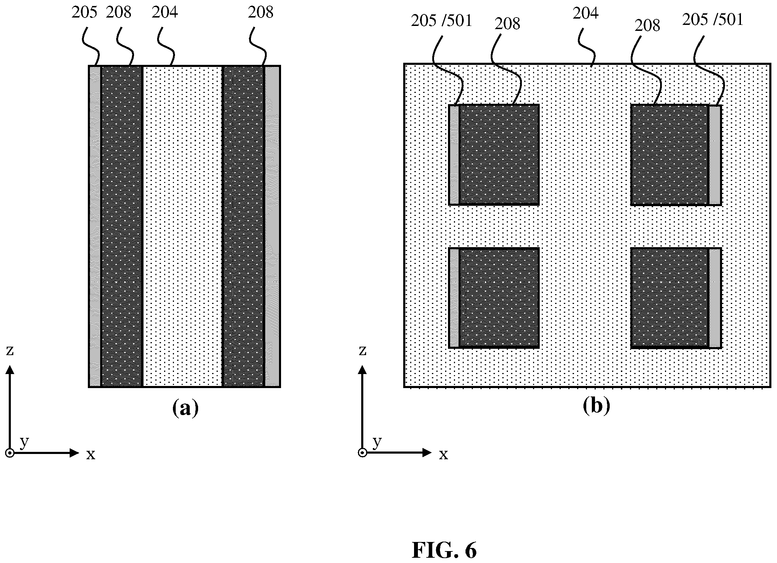

FIG. 6 shows top views of transistor devices 200 according to this disclosure. The transistor devices 200 may respectively be implemented as in FIG. 2, 3 or 4, and are based on the transistor devices 200 shown in FIG. 5. Same elements in FIG. 5 and FIG. 6 are labelled with the same reference signs, can be implemented likewise, and are thus not redundantly described. FIG. 6(a) shows a so-called stripe design of the transistor device 200 according to this disclosure, and FIG. 6(b) shows the so-called pillar design of the transistor device 200.

In contrast to the transistor devices 200 shown in FIG. 5, the transistor devices 200 shown in FIG. 6 have the gate dielectric isolation (dielectric material 205) removed, so that the gate contacts 208, and optional field plates 301 below the gate contacts 208, are direct contact with the fin structure 204.

In summary of the FIGs. 2-6, a new transistor device 200 concept is provided. The concept is a semi-vertical transistor device concept, and may be based on GaN. The transistor device 200 may combines advantages of the lateral GaN technology and advantages of vertical GaN technology. The transistor device 200 may still makes use of conventional GaN-on-silicon epitaxy, by growing the GaN buffer layer 201 on a silicon based substrate 209, but may have largely reduced device lateral dimensions thanks to the fin structure 204. The concept can be considered as a super-position of a lateral GaN HEMT and a vertical GaN JFET. The fin structure 204 may be fabricated via a regrowth process as will be described below. This fin structure 204 may sustain a significant part of the overall breakdown voltage. The threshold voltage of the transistor device 200 can be tuned by changing device dimensions, particularly of the fin structure 204. P-type dielectrics like NiO or LiNiO may be used instead of metal gate electrodes to make the field plates 301, and instead of a p-GaN layer to make the gate contacts 208. The transistor device 200 may employ compensated source field plates 301, which largely improve the overall breakdown capabilities of the transistor device 200.

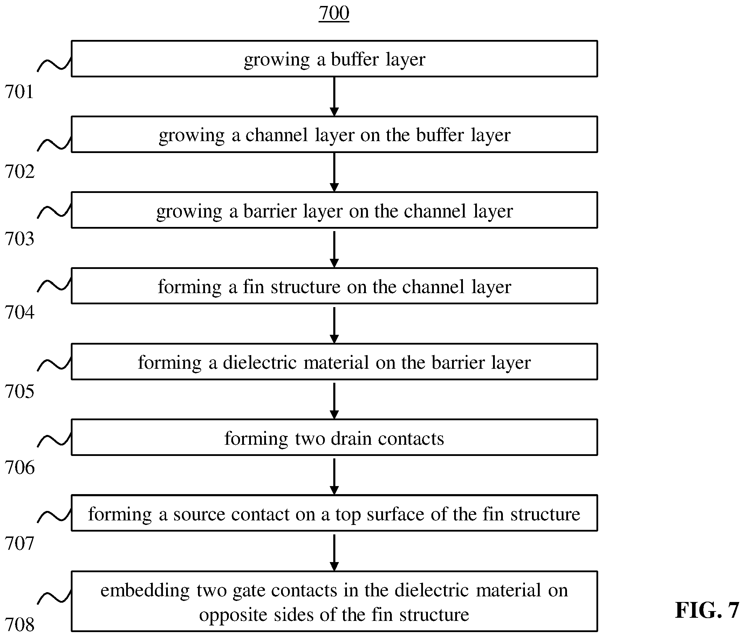

FIG. 7 shows a flow-diagram of a method 700 according to this disclosure, which is suitable for fabricating the transistor devices 200 according to this disclosure. The method 700 comprises a step 701 of growing a buffer layer 201 made of a first semiconductor material, for instance, on a substrate 209. A preferred example grows a GaN buffer layer 201 on a silicon-based substrate 209. Further, the method 200 comprises a step 702 of growing a channel layer 202 made of the first semiconductor material on the buffer layer 201, and a step 703 of growing a barrier layer 203 made of a second semiconductor material on the channel layer 202.

The method 700 further comprises a step 704 of forming a fin structure 204 made of the first semiconductor material on the channel layer 202. The fin structure 204 is formed such that it extends from the channel layer 202 along the first axis through an opening 803 in the barrier layer 203, and also extends on the channel layer 202 along the second axis. The method 700 comprises also a step 705 of forming a dielectric material 205 on the barrier layer 203. The dielectric material 205 is formed on opposite sides of the fin structure 204 along the third axis.

The method 700 further comprises a step 706 of forming two drain contacts 206, wherein each end of a channel formed in the channel layer 202 at the interface to the barrier layer 203 is electrically connected to one of the drain contacts 206, further comprises a step 707 of forming a source contact 207 on a top surface of the fin structure 204, and comprises a step 708 of embedding two gate contacts 208 in the dielectric material 205 on opposite sides of the fin structure 204.

Notably, the steps of the method 700 do not need to be performed in the order shown, in spite of the visualization with the arrows between the steps. Some steps could consist of multiple sub-steps, as will become clear in the following description. Some steps of the method 700 cold be performed interleaved with other steps.

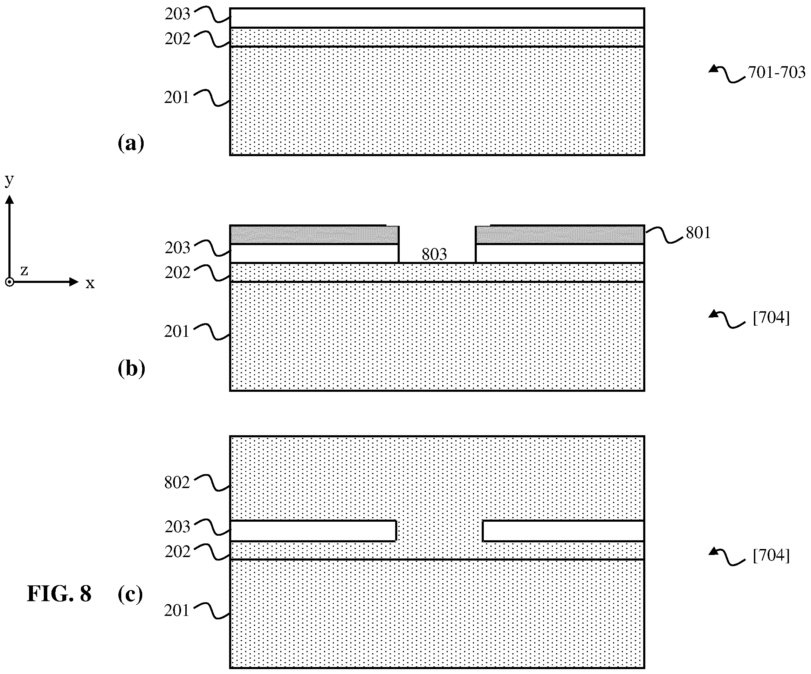

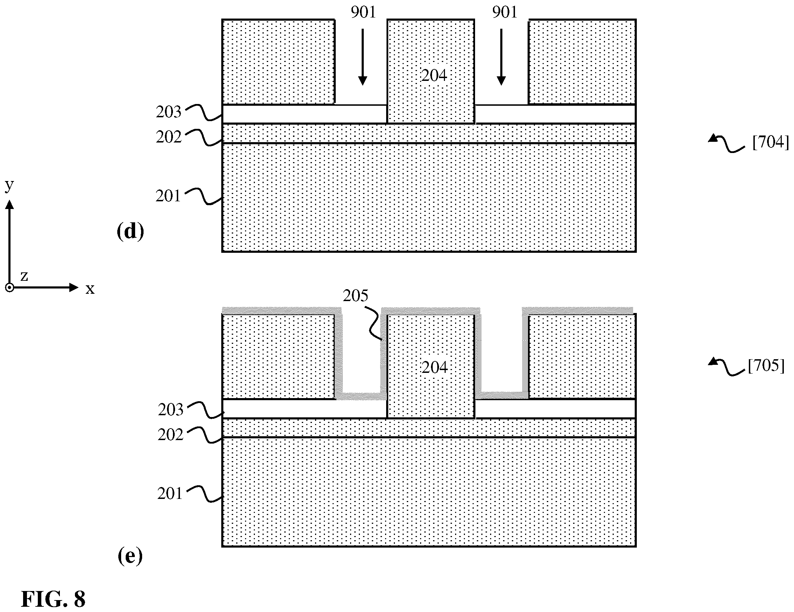

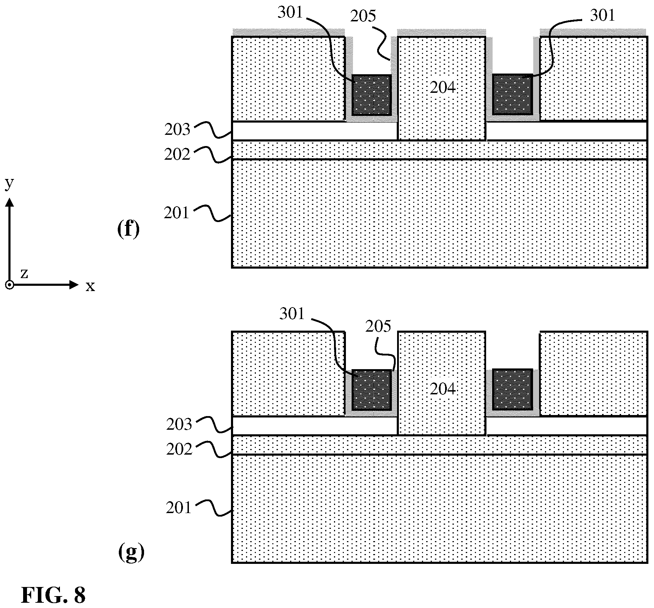

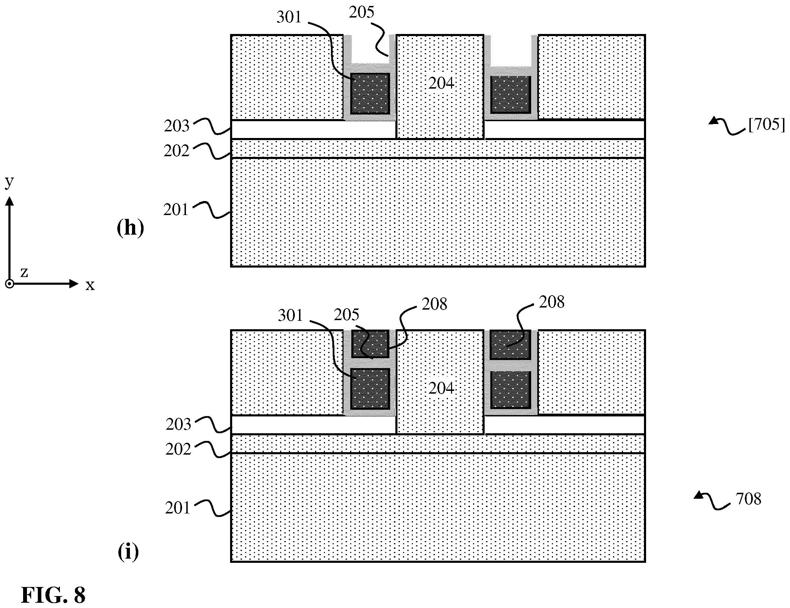

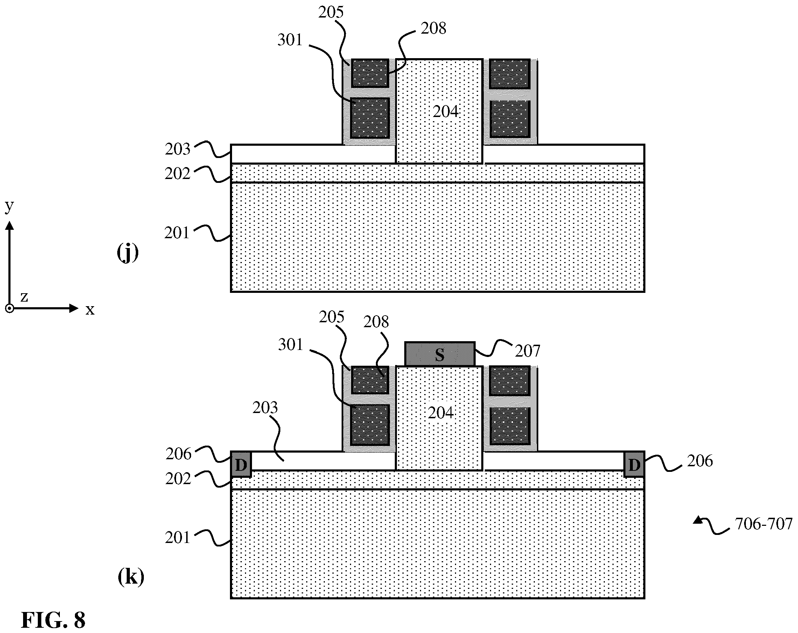

FIG. 8 (separated into FIGs. 8(a)-8(k)) shows details of an exemplary process flow for fabricating the proposed transistor device 200. In particular, the process steps for making each of the different components of the transistor device 200 are illustrated. The process steps include or implement the steps of the method 700.

FIG. 8(a) shows that at first the buffer layer 201, the channel layer 202, and the barrier layer 203 are formed, for example, are epitaxially grown. This corresponds to the steps 701-703 of the method 700. The layers 201-203 may be formed on or above a substrate 209. The structure shown in FIG. 8(a) may result from a GaN-on-Si epitaxial growth with an AlGaN barrier layer 203. The growth could use CVD, MOCVD, or MBE, for instance.

FIG. 8(b) shows that then a passivation layer 801 is formed on the barrier layer 203, and a lithography step and etch are carried out to create an opening 803 in the barrier layer 202. The opening 803 exposes the surface of the channel layer 202. The opening 803 extends along the second axis in the barrier layer 203. The forming of the opening 803 is part of (thus indicated by the brackets) the step 704 of forming the fin structure 204 in the method 700.

FIG. 8(c) shows that then a top layer 802 of first semiconductor material is grown onto the barrier layer 203 and onto the channel layer 202 through the opening 803. This step is part of the step 704 of the method 700 and constitutes a regrowth of the first semiconductor material, for instance, n-doped GaN.

FIG. 8(d) shows that then at least a part of the top layer 802 is etched down to the barrier layer 203. This etching 901 is part of the step 704 of the method 700, and the fin structure 204 is thereby formed. The etching also defines the gate contact regions.

FIG. 8(e) shows that then dielectric material 204 is deposited onto the free surface(s) of the current structure, particularly, into the etched trenches arranged next to the fin structure 204. This is part of the step 705 of the method 700.

FIG. 8(f) shows that then p-type dielectric can be deposited to form the field plates 301, if the transistor device 200 should comprise such field plates 301. Else, this step could be substituted by depositing only dielectric material 205 in place of the shown field plates 301.

FIG. 8(g) shows that then parts of the dielectric material 205 are removed, especially from the sidewalls of the trenches, which define the gate regions.

FIG. 8(h) shows that then further dielectric material 205, e.g. oxide suitable as gate isolation, is deposited. This may be part of the step 705 of the method 700.

FIG. 8(i) shows that then the gate contacts 208 are formed in the trenches next to the fin structure 204. P-type NIO or LiNiO or diamond may be, for example, electrode sputtered to this end. This corresponds to step 708 of the method 700.

FIG. 8(j) shows that then that the first semiconductor material of the top layer 802, except for the fin structure 204, is removed, for instance, etched.

FIG. 8(k) shows that then, corresponding to the steps 706 and 707 of the method 700, the drain contacts 206 and source contact 207 are formed, so as to contact the channel.

Thus, the transistor device 200 according to this disclosure - in this case as shown in FIG. 3, but the process could likewise be adapted to reach any of the previously described transistor devices 200 - is formed. The transistor device 200 has the above-described advantages, of particularly reduced device dimensions, improved breakdown voltage characteristics, and a more easily adaptable threshold voltage.

The present disclosure has been described in conjunction with various embodiments as examples as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A transistor device (200) comprising:
a buffer layer (201) made of a first semiconductor material;
a channel layer (202) made of the first semiconductor material and arranged on the buffer layer (201);
a barrier layer (203) made of a second semiconductor material and arranged on the channel layer (202);
a fin structure (204) made of the first semiconductor material and arranged on the channel layer (202), wherein the fin structure (204) extends from the channel layer (202) along a first axis (y) through an opening (803) in the barrier layer (203) and extends on the channel layer (202) along a second axis (z), which is perpendicular to the first axis (y);
a dielectric material (205) arranged on the barrier layer (203), wherein the dielectric material (205) is arranged on opposite sides of the fin structure (204) along a third axis (x), which is perpendicular to the first (y) and the second axis (z);
two drain contacts (206), wherein each end of a channel formed in the channel layer (202) at its interface to the barrier layer (203) is electrically connected to one of the drain contacts (206);
a source contact (207) arranged on a top surface of the fin structure (204); and
two gate contacts (208) embedded in the dielectric material (205) on opposite sides of the fin structure (204).

2. The transistor device (200) according to claim 1, wherein the first semiconductor material is GaN, and the second semiconductor material is AlGaN.

3. The transistor device (200) according to claim 1 or 2, wherein the gate contacts are made of nickel oxide, NiO, or lithium nickel oxide, LiNiO, or diamond.

4. The transistor device according to one of the claims 1 to 3, wherein the gate contacts (208) are p-doped, and the fin structure (204) is n-doped.

5. The transistor device (200) according to one of the claims 1 to 4, further comprising:
two field plates (301) embedded in the dielectric material (205) on opposite sides of the fin structure (204), wherein each field plate (301) is placed offset along the first axis (y) in direction of the barrier layer (203) from the gate contact (208) that is placed on the same side of the fin structure (204).

6. The transistor device (200) according to claim 5, wherein the field plates (301) are made of NiO, or LiNiO, or diamond, and/or wherein the field plates (301) are p-doped.

7. The transistor device (200) according to one of the claims 1 to 6, wherein the dielectric material (205) is arranged between the fin structure (204) and each gate contact (208).

8. The transistor device (200) according to one of the claims 1 to 6, wherein each gate contact (208) is in direct contact with the fin structure (204).

9. The transistor device (200) according to one of the claims 1 to 8, wherein the dielectric material (205) and the gate contacts (208) embedded in the dielectric material (205), respectively, extend next to the entire fin structure (204) along the second axis (z).

10. The transistor device (200) according to claim 9, wherein the dielectric material (205) and the gate contacts (208) further sandwich the fin structure (204) along the second axis (z), and the two gate contacts (208) are connected to each other to form one integral gate contact that is arranged around the fin structure (204).

11. The transistor device (200) according to one of the claims 1 to 8, wherein each of the two gate contacts (208) is embedded in a different pillar (501) of the dielectric material (205), wherein the two pillars (501) are arranged next to the fin structure (204) on opposite sides of the fin structure (204).

12. The transistor device (200) according to claim 11, comprising four or more gate contacts (208), wherein two or more pillars (501) of the dielectric material (205) are arranged on each side of the fin structure (204), and wherein each pillar (501) includes one of the gate contacts (208).

13. The transistor device (200) according to the claims 5 and 12, comprising four or more field plates (301), wherein each pillar (501) additionally includes one of the field plates (301).

14. The transistor device (200) according to claim 12 or 13, wherein the two or more pillars (501) arranged on either side of the fin structure (204) are placed one after the other along the second axis (z).

15. The transistor device (200) according to one of the claims 1 to 14, further comprising:
a second barrier layer (401) arranged on the buffer layer (201) and embedded in the channel layer (202) at an offset along the first axis (y) to the barrier layer (203);
wherein each end of a channel formed in the buffer layer (201) at its interface to the second barrier layer (401) is electrically connected to one of the drain contacts (206).

16. The transistor device (200) according to one of the claims 2 to 15, further comprising a silicon-based substrate (209) and a transition and/or nucleation layer (210) arranged between the silicon-based substrate (209) and the GaN buffer layer (201).

17. A method (700) for fabricating a transistor device (200), the method (700) comprising:
growing (701) a buffer layer (201) made of a first semiconductor material;
growing (702) a channel layer (202) made of the first semiconductor material on the buffer layer (201);
growing (703) a barrier layer (203) made of a second semiconductor material on the channel layer (202);
forming (704) a fin structure (204) made of the first semiconductor material on the channel layer (202), wherein the fin structure (204) extends from the channel layer (202) along a first axis (y) through an opening (803) in the barrier layer (203) and extends on the channel layer (202) along a second axis (z), which is perpendicular to the first axis (y);
forming (705) a dielectric material (205) on the barrier layer (203), wherein the dielectric material (205) is formed on opposite sides of the fin structure (204) along a third axis (x), which is perpendicular to the first (y) and the second axis (z);
forming (706) two drain contacts (206), wherein each end of a channel formed in the channel layer (202) at its interface to the barrier layer (203) is electrically connected to one of the drain contacts (206);
forming (707) a source contact (207) on a top surface of the fin structure (204); and
embedding (708) two gate contacts (208) in the dielectric material (205) on opposite sides of the fin structure (204).

18. The method (700) of claim 17, wherein forming (704) the fin structure (204) comprises:
forming (804) the opening (803) in the barrier layer (203);
growing (805) a top layer (802) of the first semiconductor material onto the barrier layer (203) and onto the channel layer (202) through the opening (803); and
etching (901) the top layer (802) at least partly down to the barrier layer (203), so as to form the fin structure (204).

## Amended claims

### Amended claims in accordance with Rule 137(2) EPC.

1. A transistor device (200) comprising:
a buffer layer (201) made of a first semiconductor material;
a channel layer (202) made of the first semiconductor material and arranged on the buffer layer (201);
a barrier layer (203) made of a second semiconductor material and arranged on the channel layer (202);
a fin structure (204) made of the first semiconductor material and arranged on the channel layer (202), wherein the fin structure (204) extends from the channel layer (202) along a first axis (y) through an opening (803) in the barrier layer (203) and extends on the channel layer (202) along a second axis (z), which is perpendicular to the first axis (y);
a dielectric material (205) arranged on the barrier layer (203), wherein the dielectric material (205) is arranged on opposite sides of the fin structure (204) along a third axis (x), which is perpendicular to the first (y) and the second axis (z),
two drain contacts (206), wherein each end of a channel formed in the channel layer (202) at its interface to the barrier layer (203) is electrically connected to one of the drain contacts (206), the channel being a high density electron inversion layer or two-dimensional electron gas, 2DEG;
a source contact (207) arranged on a top surface of the fin structure (204); and
two gate contacts (208) embedded in the dielectric material (205) on opposite sides of the fin structure (204).

2. The transistor device (200) according to claim 1, wherein the first semiconductor material is GaN, and the second semiconductor material is AlGaN.

3. The transistor device (200) according to claim 1 or 2, wherein the gate contacts are made of nickel oxide, NiO, or lithium nickel oxide, LiNiO, or diamond.

4. The transistor device according to one of the claims 1 to 3, wherein the gate contacts (208) are p-doped, and the fin structure (204) is n-doped.

5. The transistor device (200) according to one of the claims 1 to 4, further comprising:
two field plates (301) embedded in the dielectric material (205) on opposite sides of the fin structure (204), wherein each field plate (301) is placed offset along the first axis (y) in direction of the barrier layer (203) from the gate contact (208) that is placed on the same side of the fin structure (204).

6. The transistor device (200) according to claim 5, wherein the field plates (301) are made of NiO, or LiNiO, or diamond, and/or wherein the field plates (301) are p-doped.

7. The transistor device (200) according to one of the claims 1 to 6, wherein the dielectric material (205) is arranged between the fin structure (204) and each gate contact (208).

8. The transistor device (200) according to one of the claims 1 to 6, wherein each gate contact (208) is in direct contact with the fin structure (204).

9. The transistor device (200) according to one of the claims 1 to 8, wherein the dielectric material (205) and the gate contacts (208) embedded in the dielectric material (205), respectively, extend next to the entire fin structure (204) along the second axis (z).

10. The transistor device (200) according to claim 9, wherein the dielectric material (205) and the gate contacts (208) further sandwich the fin structure (204) along the second axis (z), and the two gate contacts (208) are connected to each other to form one integral gate contact that is arranged around the fin structure (204).

11. The transistor device (200) according to one of the claims 1 to 8, wherein each of the two gate contacts (208) is embedded in a different pillar (501) of the dielectric material (205), wherein the two pillars (501) are arranged next to the fin structure (204) on opposite sides of the fin structure (204).

12. The transistor device (200) according to claim 11, comprising four or more gate contacts (208), wherein two or more pillars (501) of the dielectric material (205) are arranged on each side of the fin structure (204), and wherein each pillar (501) includes one of the gate contacts (208).

13. The transistor device (200) according to the claims 5 and 12, comprising four or more field plates (301), wherein each pillar (501) additionally includes one of the field plates (301).

14. The transistor device (200) according to claim 12 or 13, wherein the two or more pillars (501) arranged on either side of the fin structure (204) are placed one after the other along the second axis (z).

15. The transistor device (200) according to one of the claims 1 to 14, further comprising:
a second barrier layer (401) arranged on the buffer layer (201) and embedded in the channel layer (202) at an offset along the first axis (y) to the barrier layer (203);
wherein each end of another channel formed in the buffer layer (201) at its interface to the second barrier layer (401) is electrically connected to one of the drain contacts (206), the another channel being another high density electron inversion layer or 2DEG.

16. The transistor device (200) according to one of the claims 2 to 15, further comprising a silicon-based substrate (209) and a transition and/or nucleation layer (210) arranged between the silicon-based substrate (209) and the GaN buffer layer (201).

17. A method (700) for fabricating a transistor device (200), the method (700) comprising:
growing (701) a buffer layer (201) made of a first semiconductor material;
growing (702) a channel layer (202) made of the first semiconductor material on the buffer layer (201);
growing (703) a barrier layer (203) made of a second semiconductor material on the channel layer (202);
forming (704) a fin structure (204) made of the first semiconductor material on the channel layer (202), wherein the fin structure (204) extends from the channel layer (202) along a first axis (y) through an opening (803) in the barrier layer (203) and extends on the channel layer (202) along a second axis (z), which is perpendicular to the first axis (y);
forming (705) a dielectric material (205) on the barrier layer (203), wherein the dielectric material (205) is formed on opposite sides of the fin structure (204) along a third axis (x), which is perpendicular to the first (y) and the second axis (z);
forming (706) two drain contacts (206), wherein each end of a channel formed in the channel layer (202) at its interface to the barrier layer (203) is electrically connected to one of the drain contacts (206), the channel being a high density electron inversion layer or two-dimensional electron gas, 2DEG;
forming (707) a source contact (207) on a top surface of the fin structure (204); and
embedding (708) two gate contacts (208) in the dielectric material (205) on opposite sides of the fin structure (204).

18. The method (700) of claim 17, wherein forming (704) the fin structure (204) comprises:
forming (804) the opening (803) in the barrier layer (203);
growing (805) a top layer (802) of the first semiconductor material onto the barrier layer (203) and onto the channel layer (202) through the opening (803); and
etching (901) the top layer (802) at least partly down to the barrier layer (203), so as to form the fin structure (204).
